# EUROPEAN PATENT APPLICATION

(11) **EP 4 545 984 A1**
(43) Date of publication of application: **30.04.2025**
(21) Application number: 24208618.9
(22) Date of filing: 24.10.2024
(51) Int. Cl.: G01R 31/26

(54) **POWER TRANSISTOR AGE DETECTION**

(30) Priority: 24.10.2023 US 202318493656
(71) Applicant: Infineon Technologies Canada Inc., Kanata, Ontario K2V 1C8 (CA)
(72) Inventor: MILNER, Lucas Andrew, Kanata, K2V 1C8 (CA)
(74) Representative: Kraus & Lederer PartGmbB

(57) **Abstract**

A power transistor age detection circuit that allows for end-of-life detection of a power transistor. The circuit includes the power transistor and a comparator. During a testing phase, a test current may be passed through the power transistor while on, thus inducing the input voltage at the input node of the power transistor due to its on-resistance. The comparator then compares an age test voltage that depends on the input voltage present on the input node of the power transistor against a reference voltage provided by a reference voltage source. If during the testing phase, the power transistor has aged significantly to the extent that the input voltage present at the power transistor has increased to some proportion of the reference voltage, the comparator will output the end-of-life indication signal, indicating that the power transistor has reached or is approaching its end-of-life state.

## Description

### BACKGROUND

Electronic circuits typically include transistors, which function as electronic switches that regulate or control current flow in portions of the circuit. One type of transistor is a field-effect transistor in which a voltage is applied to a gate terminal to turn the transistor on and off. A semiconductor channel region is disposed between the drain terminal and the source terminal. When the transistor is on, current flows through the semiconductor channel region between the source terminal and the drain terminal. When the transistor is off, lesser or no current flows through the semiconductor channel region between the source terminal and the drain terminal. The gate terminal is disposed over the semiconductor channel region between the source terminal and the drain terminal. Voltage on the gate terminal generates a field that affects whether the semiconductor channel region conducts current - hence the term "field-effect transistor".

Nevertheless, there are other types of transistors. In each transistor, current flows from an input node to an output node through a channel when the transistor is turned on by applying a sufficient voltage to a control node. For instance, in a field-effect transistor, the control node would be the gate terminal, the input node would be one of the source or drain terminals, and the output node would be the other of the source or drain terminals.

Typical transistors are used for amplifying and switching purposes in electronic circuits. On the other hand, power transistors are used to convey more substantial current, have higher voltage ratings, and may more typically be used in power supplies, battery charging, and the like. Power transistors can typically operate with currents greater than 1 amp to as much as a hundred amps or even greater. Power transistors may convey power greater than 1 watt to as many as hundreds of watts or even greater.

The subject matter claimed herein is not limited to embodiments that solve any disadvantages or that operate only in environments such as those described above. Rather, this background is only provided to illustrate one example technology area where some embodiments described herein may be practiced.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

A power transistor age detection circuit as defined in claim 1 is provided. The dependent claims define further embodiments.

Embodiments described herein relate to a power transistor age detection circuit that allows for end-of-life detection of a power transistor. The power transistor age detection circuit includes the power transistor and a comparator. When the power transistor is on, current is allowed to pass between an input node and an output node of the power transistor. The comparator has a first comparator input node (e.g., a negative input node) that receives a reference voltage from a reference voltage source. The comparator also has a second comparator input node (e.g., a positive input node) coupled to the input node of the power transistor such that it receives an age test voltage that depends on an input voltage present at the input node of the power transistor. Finally, the comparator has a comparator output node on which an end-of-life indication signal may be output.

When the power transistor is on, a power current is passed through the power transistor with some internal resistance (referred to as "on-resistance"). When the power transistor is off, there exists a much larger voltage drop (of potentially hundreds of volts) between the input node and the output node of the power transistor. Power transistors are susceptible to "aging" over time due to high electric fields caused by such large voltage drops. When a power transistor experiences aging, it may have an increase in on-resistance. This causes the power transistor to be less efficient at passing current since more power is lost due to heat. At some point, the power transistor will fail. The principles described herein detect aging in advance of the transistor failing so that remedial measures may be taken, such as replacing the power transistor.

To determine whether the power transistor is approaching its end-of-life state, a testing phase may be initiated when the power transistor age detection circuit is turned on. During this testing phase, a test current may be passed through the power transistor while on, thus inducing the input voltage at the input node of the power transistor due to its on-resistance. The comparator then compares the age test voltage that depends on the input voltage present on the input node of the power transistor against the reference voltage provided by the reference voltage source. The reference voltage is selected at the time of manufacture of the power transistor age detection circuit, and may take into account trimming due to process variations experienced by the power transistor during manufacture.

If, during the testing phase, the input voltage at the power transistor has not increased to at least some threshold amount above the reference voltage (due to increased on-resistance from aging), the comparator will not output an end-of-life indication signal. However, if during the testing phase, the power transistor has aged significantly to the extent that the input voltage present at the power transistor has increased to at least the threshold amount above the reference voltage, the comparator will output the end-of-life indication signal, indicating that the power transistor has reached or is approaching its end-of-life state.

Accordingly, the embodiments described herein allow for the power transistor age detection circuit to accurately detect aging of the power transistor in advance of the power transistor failing. Such failing could result in problems such as overheating, junction breakdown, or insulation breakdown, which could cause damage not only to the power transistor itself, but also to other components contained within or coupled to a circuit that contains the power transistor. Thus, by using the power transistor age detection circuit to accurately detect aging of the power transistor in advance of the power transistor failing, remedial measures (e.g., replacement of the power transistor) may be taken that prevent damage to the power transistor and any associated components or circuitry.

Additional features and advantages will be set forth in the description which follows, and in part will be obvious from the description, or may be learned by the practice of the teachings herein. Features and advantages of the invention may be realized and obtained by means of the instruments and combinations particularly pointed out in the appended claims. Features of the present invention will become more fully apparent from the following description and appended claims, or may be learned by the practice of the invention as set forth hereinafter.

### BRIEF DESCRIPTION OF THE DRAWINGS

In order to describe the manner in which the advantages and features of the systems and methods described herein can be obtained, a more particular description of the embodiments briefly described above will be rendered by reference to specific embodiments thereof which are illustrated in the appended drawings. Understanding that these drawings depict only typical embodiments of the systems and methods described herein, and are not therefore to be considered to be limiting of their scope, certain systems and methods will be described and explained with additional specificity and detail through the use of the accompanying drawings in which:
Figure 1 illustrates a power transistor age detection circuit in which the principles described herein may be practiced, and in which input voltage of a power transistor is compared against a reference voltage in order to detect aging of the power transistor, in accordance with the principles described herein; and
Figure 2 illustrates an example power transistor age detection circuit that is an example of the power transistor age detection circuit of Figure 1.

### DETAILED DESCRIPTION

Embodiments described herein relate to a power transistor age detection circuit that allows for end-of-life detection of a power transistor. The power transistor age detection circuit includes the power transistor and a comparator. When the power transistor is on, current is allowed to pass between an input node and an output node of the power transistor. The comparator has a first comparator input node (e.g., a negative input node) that receives a reference voltage from a reference voltage source. The comparator also has a second comparator input node (e.g., a positive input node) coupled to the input node of the power transistor such that it receives an age test voltage that depends on an input voltage present at the input node of the power transistor. Finally, the comparator has a comparator output node on which an end-of-life indication signal may be output.

When the power transistor is on, a power current is passed through the power transistor with some internal resistance (referred to as "on-resistance"). When the power transistor is off, there exists a much larger voltage drop (of potentially hundreds of volts) between the input node and the output node of the power transistor. Power transistors are susceptible to "aging" over time due to high electric fields caused by such large voltage drops. When a power transistor experiences aging, it may have an increase in on-resistance. This causes the power transistor to be less efficient at passing current since more power is lost due to heat. At some point, the power transistor will fail. The principles described herein detect aging in advance of the transistor failing so that remedial measures may be taken, such as replacing the power transistor.

To determine whether the power transistor is approaching its end-of-life state, a testing phase may be initiated when the power transistor age detection circuit is turned on. During this testing phase, a test current may be passed through the power transistor while on, thus inducing the input voltage at the input node of the power transistor due to its on-resistance. The comparator then compares the age test voltage that depends on the input voltage present on the input node of the power transistor against the reference voltage provided by the reference voltage source. The reference voltage is selected at the time of manufacture of the power transistor age detection circuit, and may take into account trimming due to process variations experienced by the power transistor during manufacture.

If, during the testing phase, the input voltage at the power transistor has not increased to at least some threshold amount above the reference voltage (due to increased on-resistance from aging), the comparator will not output an end-of-life indication signal. However, if during the testing phase, the power transistor has aged significantly to the extent that the input voltage present at the power transistor has increased to at least the threshold amount above the reference voltage, the comparator will output the end-of-life indication signal, indicating that the power transistor has reached or is approaching its end-of-life state.

Accordingly, the embodiments described herein allow for the power transistor age detection circuit to accurately detect aging of the power transistor in advance of the power transistor failing. Such failing could result in problems such as overheating, junction breakdown, or insulation breakdown, which could cause damage not only to the power transistor itself, but also to other components contained within or coupled to a circuit that contains the power transistor. Thus, by using the power transistor age detection circuit to accurately detect aging of the power transistor in advance of the power transistor failing, remedial measures (e.g., replacement of the power transistor) may be taken that prevent damage to the power transistor and any associated components or circuitry.

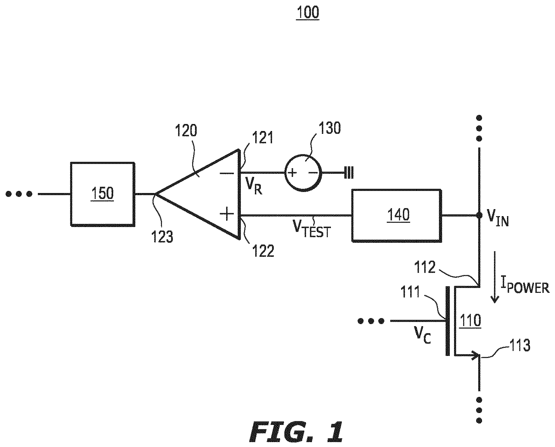

Figure 1 illustrates a power transistor age detection circuit 100 in which the principles described herein may be practiced, and is just one example of a power transistor age detection circuit that is consistent with the principles described herein. The power transistor age detection circuit 100 includes a power transistor 110 and a comparator 120. The comparator 120 and its operation will be described later.

In Figure 1, the power transistor 110 is illustrated using a symbol often used for field-effect transistors. However, the principles described herein are not limited to the power transistor 110 being a field-effect transistor. The power transistor 110 may be any transistor capable of transmitting current when on. For instance, the power transistor 110 may be any transistor capable of transmitting more than 1 watt of power when on. If a field-effect transistor, the power transistor 110 is not limited to being any particular type of field-effect transistor. As examples only, the power transistor 110 may be a gallium-nitride field-effect transistor, or a high-electron mobility transistor. However, the principles described herein are not limited to the power transistor 110 being any particular kind of transistor, and need not even be a field-effect transistor.

When the power transistor 110 is on, for example by a control voltage Vc in a high state being applied to a control node 111 of the power transistor 110, a power current I_{POWER} is passed through the power transistor 110 from an input node 112 to an output node 113 of the power transistor 110. This is because an input voltage V_{IN} that is present on the power transistor input node 112 is higher than the voltage present on the output node 113. For example, the power transistor output node 113 may be grounded. For the remainder of this description, for illustrative purposes, the operation of the power transistor age detection circuit 100 will be described as though the output node 113 is grounded.

The power transistor 110 has some on-resistance. Thus, assuming that the output node 113 is grounded, when the power transistor 110 is on, the on-resistance will induce an input voltage V_{IN} that is equal to the product of the on-resistance and the current passing through the power transistor 110. This on-resistance can be quite low, and thus the input voltage V_{IN} present while the power transistor 110 is on may also be relatively low (e.g., less than 5 volts). However, as the power transistor 110 ages, the on-resistance increases, and thus the input voltage V_{IN} while the power transistor 110 is on, would increase proportionally.

When the power transistor 110 is off, for example by the control voltage Vc being low, current no longer flows through the power transistor 110, and the input voltage V_{IN} becomes high (e.g., hundreds of volts). This is done by a pull-up network (not shown) connected to the input node 112 of the power transistor 110. The high voltage difference that occurs between the input node 112 and the output node 113 of the power transistor 110 when the power transistor 110 is off may cause the power transistor 110 to age over time, thus increasing the internal on-resistance of the power transistor 110. Accordingly, when the internal on-resistance of the power transistor 110 increases, the input voltage V_{IN} of the power transistor 110 when on also increases proportionally.

The comparator 120 has a first comparator input node 121 (e.g., a negative input node), a second comparator input node 122 (e.g., a positive input node), and a comparator output node 123. The first comparator input node 121 is connected to a reference voltage source 130 that provides a reference voltage V_{R}. The second comparator input node 122 is coupled to the input node 112 of the power transistor 110 via an intermediary circuit 140, such that the intermediary circuit 140 outputs an age test voltage V_{TEST} that depends on the input voltage V_{IN} that is applied to the power transistor input node 112.

For example, if the intermediary circuit 140 was a voltage divider, the age test voltage V_{TEST} would be some proportion of the input voltage V_{IN}. In the remainder of this description, for illustrative purposes only, the intermediary circuit 140 will be described as a voltage divider 140 outputting an age test voltage V_{TEST} that is N times the input voltage V_{IN}, wherein N is a fraction between zero and one. N may even be one, in which case the second comparator input node 122 would be connected directly to the input node 112 of the power transistor 110.

The power transistor age detection circuit 100 also includes an age detection circuit 150 that is connected to the comparator output node 123. The age detection circuit 150 interprets signals from the comparator output node 123, as will be explained later.

In operation, the power transistor age detection circuit 100 may enter a testing phase in which a test power current I_{POWER} (e.g., one amp) is passed through the power transistor 110, thereby inducing an input voltage V_{IN} at the input node 112 of the power transistor 110 while the power transistor 110 is on. The voltage divider 140 outputs an age test voltage V_{TEST} that depends on the input voltage V_{IN}. For example, the voltage divider 140 outputs the age test voltage V_{TEST} that is equal to N x V_{IN}. The values of N and V_{R} are chosen such that when the input voltage V_{IN} becomes 1/N times the reference voltage V_{R}, the power transistor 110 has reached or is approaching its end-of-life state. The value of V_{R} may be a trimmed value set after determining characteristic properties of the power transistor 110 at the time of manufacture.

The comparator 120 compares the age test voltage V_{TEST} present at the second comparator input node 122 against the reference voltage V_{R} present at the first comparator input node 121. If during the testing phase, and while the power transistor 110 is on, the input voltage V_{IN} has not increased at least to some threshold voltage proportion (e.g., 1/N) of the reference voltage V_{R} (due to an increase in on-resistance from aging), the comparator 120 outputs a low signal to the comparator output node 123. The age detection circuit 150 may interpret the low signal from the comparator output node 123 as an indication that the power transistor 110 has not yet aged to its end-of-life state. Alternatively, if positive comparator input terminal 121 is connected to receive the reference voltage V_{R} and the negative comparator input terminal 122 is connected to receive the age test voltage V_{TEST}, the age detection circuit 150 may interpret a high signal from the comparator output node 123 as an indication that the power transistor 110 has not yet aged its end-of-life state.

However, if during the testing phase, the power transistor 110 has aged significantly to the extent that the input voltage V_{IN} has increased to at least the threshold voltage proportion (e.g., 1/N) of the reference voltage V_{R}, the comparator 120 outputs a high signal to the comparator output node 123. The age detection circuit 150 may interpret the high signal from the comparator output node 123 as an indication that the power transistor 110 has reached or is at least approaching its end-of-life state. Alternatively, if positive comparator input terminal 121 is connected to receive the reference voltage V_{R} and the negative comparator input terminal 122 is connected to receive the age test voltage V_{TEST}, the age detection circuit 150 may interpret a low signal from the comparator output node 123 as an indication that the power transistor 110 has reached or is at least approaching its end-of-life state. Accordingly, the power transistor age detection circuit 100 detects aging of the power transistor 110 in advance of the power transistor 110 failing so that remedial measures may be taken, such as replacing the power transistor 110.

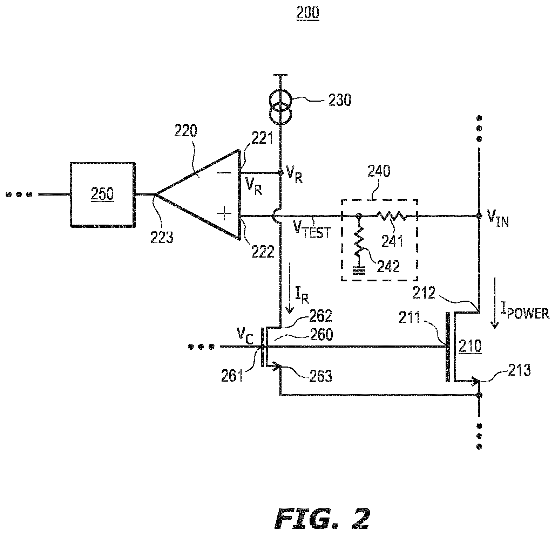

Figure 2 illustrates an example power transistor age detection circuit 200 that is an example of the power transistor age detection circuit 100 of Figure 1. Specifically, the power transistor 210, comparator 220, voltage divider 240 and age detection circuit 250 of Figure 2 are respective examples of the power transistor 110, comparator 120, intermediary circuit 140 and age detection circuit 150 of Figure 1. However, the power transistor age detection circuit 200 further includes a reference transistor 260 and reference current source 270, which collectively act as an example of the reference voltage source 130 of Figure 1, as will be described further below.

A control node 261 of the reference transistor 260 and the control node 211 of the power transistor 210 are connected to each other. An output node 263 of the reference transistor 260 and the output node 213 of the power transistor 210 are also connected to each other. An input node 262 of the reference transistor 260 is connected to the first comparator input node 221, and receives a reference current I_{R} from the reference current source 270.

In one embodiment, the reference transistor 260 is an approximate replica of the power transistor 210, except for the current flow area of the power transistor 210 being M times larger than the current flow area of the reference transistor 260. M is a number that represents a size ratio of the current flow area of the power transistor 210 over the current flow area of the reference transistor 260 and may be, for example, 500 or more. For example, the reference transistor 260 may be a miniaturized replica of the power transistor 210 when the active regions of both transistors are fabricated using the same epitaxial stack, except for the current flow area being M times larger for the power transistor 210.

If using the same epitaxial stack, if the power transistor 210 was a field-effect transistor, the reference transistor 260 may also be a field-effect transistor of the same type but smaller. Similarly, if the power transistor 210 was a gallium-nitride transistor, the reference transistor 260 may also be a gallium-nitride transistor of the same type but smaller. Further, if the power transistor 210 was a high-electron-mobility transistor, the reference transistor 260 may also be a high-electron-mobility transistor of the same type but smaller. Use of the same epitaxial stack to formulate both the power transistor 210 and the reference transistor 260 allows for the circuit to be manufactured without unduly complicating the fabrication process.

Both of the power transistor 210 and the reference transistor 260 have some on-resistance. That is, when the power transistor 210 is on, its on-resistance will induce an input voltage V_{IN} that is equal to the product of its on-resistance and the current passing through the power transistor 210. Likewise, when the reference transistor 260 is on, its on-resistance will induce an input voltage (that is the reference voltage V_{R}) that is equal to the product of its on-resistance and the reference current I_{R} passing through the reference transistor 260. Accordingly, in the embodiment of Figure 2, the reference transistor 260 and the reference current source 270 collectively act to provide the reference voltage V_{R}.

As previously expressed with respect to Figure 1, while the power transistor 210 is off, the power transistor 210 may experience a large voltage drop (e.g., hundreds of volts) between its input node 212 and its output node 213. However, while the reference transistor 260 is off, the reference transistor 260 may not experience a large voltage drop between its input node 262 and its output node 263 at all. Accordingly, the reference transistor 260 does not age quite as does the power transistor 210, and thus the reference voltage V_{R} is relatively stable.

The voltage divider 240 outputs an age test voltage V_{TEST} that depends on the input voltage V_{IN}. For example, the voltage divider 240 outputs the age test voltage V_{TEST} that is equal to N x V_{IN}. The values of N and V_{R} are chosen such that when the input voltage V_{IN} becomes 1/N times the reference voltage V_{R}, the power transistor 210 has reached or is approaching its end-of-life state. A voltage divider is a suitable intermediating component between the input node 212 of the power transistor 210 and the second comparator terminal 222, in the case in which N is between zero and one (e.g., the test voltage V_{TEST} is a fraction of the input voltage V_{IN}. Once the appropriate value of N is chosen, the resistance values of the resistors 241 and 242 may also be appropriately chosen, such the R₂/(R₁+R₂) = N (wherein R₁ is the resistance of resistor 241, and R₂ is the resistance of resistor 242). That said, a voltage divider can be constructed out of circuit elements other than resistors, and thus, the principles described herein are not limited to the voltage divider 240 of Figure 2.

Other than the manner in which the reference voltage V_{R} is generated, and the manner in which the test voltage V_{TEST} is generated from the input voltage V_{IN}, the power transistor age detection circuit 200 of Figure 2 may otherwise operate as described above for the power transistor age detection circuit 100 of Figure 1.

Accordingly, the embodiments described herein allow for the power transistor age detection circuit to accurately detect aging of the power transistor in advance of the power transistor failing. Such failing could result in problems such as overheating, junction breakdown, or insulation breakdown, which could cause damage not only to the power transistor itself, but also to other components contained within or coupled to a circuit that contains the power transistor. Thus, by using the power transistor age detection circuit to accurately detect aging of the power transistor in advance of the power transistor failing, remedial measures (e.g., replacement of the power transistor) may be taken that prevent damage to the power transistor and any associated components or circuitry.

### Literal Support Section

Clause 1. A power transistor age detection circuit comprising: a power transistor configured to pass current from a power transistor input node to a power transistor output node when the power transistor is on, an input voltage is present on the power transistor input node, and an output voltage that is lower than the input voltage is present on the power transistor output node; a comparator having a first comparator input node that is configured to receive a reference voltage, and a second comparator input node that is coupled to the power transistor input node so as to be configured to receive an age test voltage that depends on the input voltage that is applied to the power transistor input node, the comparator being also configured to output a signal indicative of a status of the reference voltage with respect to the age test voltage; and an age detection circuit configured to receive the signal output from the comparator, and detect aging of the power transistor when the comparator, while the power transistor is on, outputs a signal indicative of particular status of the reference voltage with respect to the age test voltage.

Clause 2. The power transistor age detection circuit according to Clause 1, wherein the particular status is that the age test voltage is greater than the reference voltage.

Clause 3. The power transistor age detection circuit according to Clause 1, the age test voltage is proportional to the input voltage of the power transistor.

Clause 4. The power transistor age detection circuit according to Clause 3, the power transistor age detection circuit further comprising a voltage divider having an output connected to the second comparator input node, such that the age test voltage is less than the input voltage of the power transistor.

Clause 5. The power transistor age detection circuit according to Clause 1, wherein the power transistor is a field-effect transistor.

Clause 6. The power transistor age detection circuit according to Clause 5, wherein the power transistor is a gallium-nitride transistor.

Clause 7. The power transistor age detection circuit according to Clause 1, wherein the power transistor is a high-electron-mobility transistor.

Clause 8. The power transistor age detection circuit according to Clause 1, further comprising: a reference current source configured to provide a reference current through a voltage divider, the reference voltage generated on an output of the voltage divider.

Clause 9. The power transistor age detection circuit according to Clause 8, a resistor of the voltage divider comprising a reference transistor in an on state.

Clause 10. The power transistor age detection circuit according to Clause 9, the second comparator input node coupled to the power transistor input node such that the age test voltage is less than 90 percent of the input voltage at the power transistor input node.

Clause 11. The power transistor age detection circuit according to Clause 9, the second comparator input node coupled to the power transistor input node such that the age test voltage is less than 75 percent of the input voltage at the power transistor input node.

Clause 12. The power transistor age detection circuit according to Clause 9, wherein the power transistor and the reference transistor are field-effect transistors.

Clause 13. The power transistor age detection circuit according to Clause 12, wherein the power transistor and the reference transistors are gallium-nitride transistors.

Clause 14. The power transistor age detection circuit according to Clause 12, wherein the power transistor and the reference transistor are high-electron-mobility transistors.

Clause 15. The power transistor age detection circuit according to Clause 12, the power transistor and the reference transistor each having active regions formed from a same epitaxial stack.

Clause 16. The power transistor age detection circuit according to Clause 12, wherein a size ratio of a current flow area of the power transistor over a current flow area of the reference transistor is 500 or more.

Although the subject matter has been described in language specific to structural features and/or methodological acts, it is to be understood that the subject matter defined in the appended claims is not necessarily limited to the described features or acts described above, or the order of the acts described above. Rather, the described features and acts are disclosed as example forms of implementing the claims.

The present disclosure may be embodied in other specific forms without departing from its essential characteristics. The described embodiments are to be considered in all respects only as illustrative and not restrictive. All changes which come within the meaning and range of equivalency of the claims are to be embraced within their scope.

When introducing elements in the appended claims, the articles "a," "an," "the," and "said" are intended to mean there are one or more of the elements. The terms "comprising," "including," and "having" are intended to be inclusive and mean that there may be additional elements other than the listed elements.

## Claims

1. A power transistor age detection circuit comprising:
a power transistor configured to pass current from a power transistor input node to a power transistor output node when the power transistor is on, an input voltage is present on the power transistor input node, and an output voltage that is lower than the input voltage is present on the power transistor output node;
a comparator having a first comparator input node that is configured to receive a reference voltage, and a second comparator input node that is coupled to the power transistor input node so as to be configured to receive an age test voltage that depends on the input voltage that is applied to the power transistor input node, the comparator being also configured to output a signal indicative of a status of the reference voltage with respect to the age test voltage; and
an age detection circuit configured to receive the signal output from the comparator, and detect aging of the power transistor when the comparator, while the power transistor is on, outputs a signal indicative of particular status of the reference voltage with respect to the age test voltage.

2. The power transistor age detection circuit according to Claim 1, wherein the particular status is that the age test voltage is greater than the reference voltage.

3. The power transistor age detection circuit according to Claim 1 or 2, the age test voltage is proportional to the input voltage of the power transistor.

4. The power transistor age detection circuit according to Claim 3, the power transistor age detection circuit further comprising a voltage divider having an output connected to the second comparator input node, such that the age test voltage is less than the input voltage of the power transistor.

5. The power transistor age detection circuit according to any one of Claims 1 to 4, wherein the power transistor is a field-effect transistor.

6. The power transistor age detection circuit according to Claim 5, wherein the power transistor is a gallium-nitride transistor and/or a high-electron-mobility transistor .

7. The power transistor age detection circuit according to any one of Claims 1 to 6, further comprising:
a reference current source configured to provide a reference current through a voltage divider, the reference voltage generated on an output of the voltage divider.

8. The power transistor age detection circuit according to Claim 7, a resistor of the voltage divider comprising a reference transistor in an on state.

9. The power transistor age detection circuit according to Claim 8, wherein the power transistor and the reference transistor are field-effect transistors.

10. The power transistor age detection circuit according to Claim 9, wherein the power transistor and the reference transistors are gallium-nitride transistors.

11. The power transistor age detection circuit according to Claim 9 or 10, wherein the power transistor and the reference transistor are high-electron-mobility transistors.

12. The power transistor age detection circuit according to any one of Claims 8 to 11, the power transistor and the reference transistor each having active regions formed from a same epitaxial stack.

13. The power transistor age detection circuit according to any one of Claims 8 to 12, wherein a size ratio of a current flow area of the power transistor over a current flow area of the reference transistor is 500 or more.

14. The power transistor age detection circuit according to any one of Claims 1 to 13, the second comparator input node coupled to the power transistor input node such that the age test voltage is less than 90 percent of the input voltage at the power transistor input node.

15. The power transistor age detection circuit according to Claim 14, the second comparator input node coupled to the power transistor input node such that the age test voltage is less than 75 percent of the input voltage at the power transistor input node.
